Europäisches Patentamt

European Patent Office

Office européen des brevets

(19)

(11) Publication number: **0 262 610**
**A2**

(12) **EUROPEAN PATENT APPLICATION**

(21) Application number: **87114045.5**

(22) Date of filing: **25.09.87**

(51) Int. Cl.4 **H01L 29/10 , H01L 29/80**

(30) Priority: **29.09.86 US 913049**

(43) Date of publication of application:
**06.04.88 Bulletin 88/14**

(84) Designated Contracting States:
**DE FR GB**

(71) Applicant: **Siemens Aktiengesellschaft Berlin und München**
**Wittelsbacherplatz 2**
**D-8000 München 2(DE)**

(72) Inventor: **Kohn, Erhard**
**6 State Park Drive**
**Titusville, NJ 08560(US)**
Inventor: **Hofmann, Karl R.**
**4 Schuh Road**
**Kingston, NJ 08528(US)**

(54) **Two-dimensional electron gas switching device.**

(57) A field effect device utilizes heterojunction interfaces at the upper interface (20) and lower interfaces (21) of its channel (16) for the formation of two-dimensional electron gases (2-DEGs). The channel (16) is divided into two portions each under one of two selector gates (22, 23). The device is switched on by aligning the two 2-DEGs under the control of two selector gates to be at the same interface completing a conduction path between the drain and source terminals of the device. The device is switched off by mis-aligning the two 2-DEGs in accordance with different bias potentials at the two selector gates to be at opposite interfaces in the channel zone. A branched channel zone utilized to provide switching between a common electrode and a pair of electrodes. The common electrode may be either the drain or the source.

FIG. 1

# TWO-DIMENSIONAL ELECTRON GAS SWITCHING DEVICE

## BACKGROUND OF THE INVENTION

The present invention relates to a switching logic device in the form of a field effect transistor configuration. More particularly, this invention relates to a double heterojunction structure in a logic device providing an upper conduction channel and a lower conduction channel each capable of producing and confining a quasi-two-dimensional electron gas (2 DEG). In the logic device, switching on is produced by moving a 2 DEG from one channel to the other channel to provide channel alignment completing conduction between source and drain terminals of the device. Switching off also involves moving a 2 DEG between channels but to produce misalignment preventing or disrupting conduction between source and drain terminals of the device.

It has become common practice to utilize field effect transistors (FETs) in both discrete and integrated circuits due to their desirable electrical characteristics in both switching applications and amplifying functions. Another advantage of the FET is their relatively simple structure for ease of fabrication processing. The fundamental operation of conventional FETs involves modulating the density of charge carriers traversing conduction channels in a semiconductor medium extending between source and drain electrodes in response to a signal potential applied to one or more gate electrodes. Thus, the gate electrode controls the electrical conductivity between the source and drain electrode.

A limiting factor in the high speed performance of most conventional FET devices is determined by the channel transit time of the charge carriers take in traveling the length of the conduction path spanning between the drain and source electrodes. The channel transit time is directly proportional to the channel length and inversely proportional to the carrier velocity. The minimum achievable channel transit time is on the order or one picosecond ($10^{-12}$ second) with minimum channel length and fastest carrier velocity. Typical high speed devices of this type are known as gallium arsenide Schottky field effect transistors. Therefore in presently available high speed devices using charge density modulation, it is still not possible to reduce the response time to be less than one picosecond since the full effect of the modulation on the charge carriers by a fast changing gate signal is substantially equal to the time consumed by the charge carriers in traversing over the channel length.

## SUMMARY OF THE INVENTION

An object of the present invention is to control selectively the formation of one or more electron gases in a double heterojunction or double quantum well device structure to achieve extremely high speed switching operation.

It is an object of the invention to provide a high speed switching device utilizing planar fabrication technology while reducing the area occupied by the device.

It is a related object to provide a current branching device configuration utilizing either dual source or dual drain electrodes each individually associated with one of the two possible locations of a quasi-two-dimensional electron gases in a double heterojunction device structure.

It is a further object to provide a versatile logic switching device in terms of options for biasing gate electrodes to provide switching operation.

Broadly, the invention takes the form of a double heterojunction semiconductor device wherein control in the establishment of a quasi-two-dimensional electron gas at one location via a gate terminal between two possible locations is used to complete or prevent the formation of a continuous conduction channel from a first terminal to another terminal of the device.

In a principle aspect of the invention, a FET device configuration includes a channel capable of supporting two-electron gases at two different locations wherein the formation of an electron gas in a predetermined portion of the channel is allowed to occur at only a selected one of the two different locations. When at least two predetermined portions of the channel contain an electron gas at the same location thereby completing a conduction path between two terminals of the device, the corresponding portion of the device assumes an on-state. When at least two predetermined portions of the channel contain electron gases at different locations displaced from one another or misaligned, the conduction path is not complete between the two associated terminals so that the associated portion of the device assumes an off-state.

In some of the further aspects of the invention, changing the polarity of the electrical field oriented normal with respect to the longitudinal orientation of the channel shifts the formation of two possible electron gases at each of the two heterojunction interfaces to only one or the other location for a single electron gas at one heterojunction interface thereby completing or interrupting the conduction path between source and drain terminals of the device to provide high speeding switching operation. Either two (paired) drain electrodes or two (paired) source electrodes provide a device configuration wherein the selected portion of the channel abutting the associated zone or paired electrodes is arranged to support only one electron gas in a predetermined location. By switching the location of an electron gas in another selected portion of the channel between a source electrode and a drain electrode and interrupted between the common electrode and the other one of the two paired electrodes.

## BRIEF DESCRIPTION OF THE DRAWING

Features of the invention and additional objects of the invention will be more readily appreciated and better understood by reference to the following detailed description which should be considered in conjunction with the drawing.

Fig. 1 is a cross-sectional view of an illustrative device useful in demonstrating the principle and operation of the invention.

Fig. 2 illustrates a branching or dual terminal device configuration capable of high switching speed operation.

Fig. 3 is a cross-section view of the branching device of Fig. 2 in a dual drain structure.

Fig. 4 is a cross-sectional view of the branching device of Fig. 2 in a dual source structure.

Figs. 5, 6, and 7 are tables lisiting suitable structural parameters for fabricating the new device structure by molecular beam epitaxy (MBE) techniques.

## DETAILED DESCRIPTION

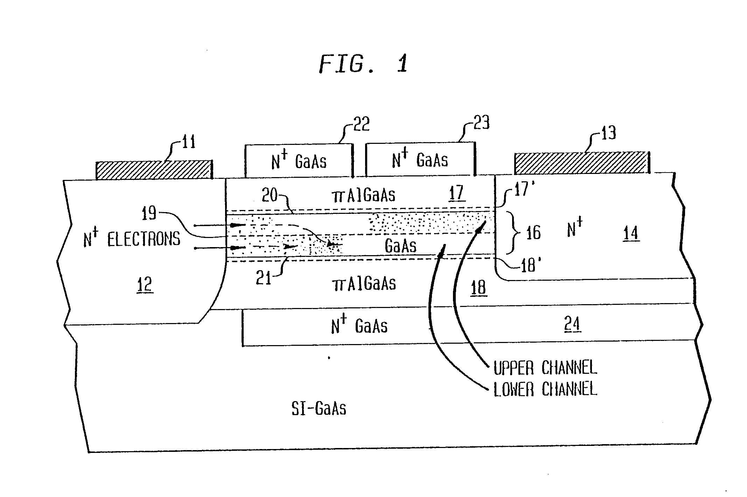

Fig. 1 is a cross-sectional view of a channel portion of an illustrative device for demonstrating the fundamental operational principles of the invention. At the outset, it is to be understood that the various device structures such as Fig. 1 and other figures are illustrated in enlarged versions which are also not in correct proportions for the purpose of clearly illustrating the structure. For example, very thin layers are depicted with exaggerated thickness.

The basic structure of the device of Fig. 1 corresponds to a field effect transistor (FET) including source contact 11 for providing, in this case, a source of electon charge carriers from source zone 12. Source zone 11 under appropriate biasing with respect to drain contact 13 and associated drain zone 14 emits electrons into channel zone 16 bounded on its upper and lower regions by upper zone 17 and a lower zone 18 to form an upper interface and a lower interface channel structure. For the sake of understanding the operation of the switching device of Fig. 1, channel zone 16 is divided into upper and lower channels by dotted line 19. This is due to the fact that a first two-dimensional electron gas may exist of charge carriers (electrons) between the upper interface 20 of zones 16 and 17 and a second two-dimensional electron gas may exist of charge carriers (electrons) between the lower interface 21 of zones 16 and 18. Therefore, dotted line 19 indicates the formation of two separate channels (upper and lower) within zone 16.

The material of zones 17 and 18 possess a higher conduction band energy than the intermediate material of channel zone 16. A suitable material is $Al_x Ga_{1-x}$ As for zones 17 and 18. Since zones 17 and 18 have the same composition, the two electron gases providing conduction channels are formed of charge carriers exhibiting the same mobility at the two equivalent heterojunction interfaces of n-AlGaAs and the relatively high purity (undoped) GaAs material of channel zone 16. It should be understood that different combinations of materials may also be used to provide the dual heterojunction structure.

In order to control the conduction characteristic of zone 16, at least one electric field is established normal to the longitudinal axis and orientation of the zone. On the external boundary of zone 17, a first gate electrode 22 is placed along side of a second gate electrode 23 for establishing normal electric fields with respect to common gate electrode 24. It is to be understood that gate (back) electrode 24 is not necessarily essential and the same or equivalent operation will occur in its absence. Although electrons are emitted from zone 12 to form both electron gases at interfaces 20 and 21, an electric field established between gate electrode 22 and common gate electrode 24 has the ability to favor only one of the two possible interfaces for the formation and containment of a single electron gas of charge carriers. As would be evident to those skilled in the art, the electron gas depending upon the polarity of the electric field may favor formation at either the upper interface 20 or the lower interface 21.

Similarly, a second electric field established between second gate electrode 23 and common electrode 24 will have a corresponding effect in that portion of zone 16 passing through this electric field. Switching of the device of Fig. 1 to the on-state is accomplished by aligning the two independent electron gases to form a complete conduction channel. Conversely by displacing the two electron gases from each other to lie at the opposite interfaces of zone 16 thereby interrupting the conduction path between source 11 and drain 13 switches the device of Fig. 1 to the off-state. Since this mechanism of switching between the two possible locations of the electron gas is independent of the carrier transit time consumed in propagating the length of zone 16, extremely high speed switching will result in the utilization of this principle.

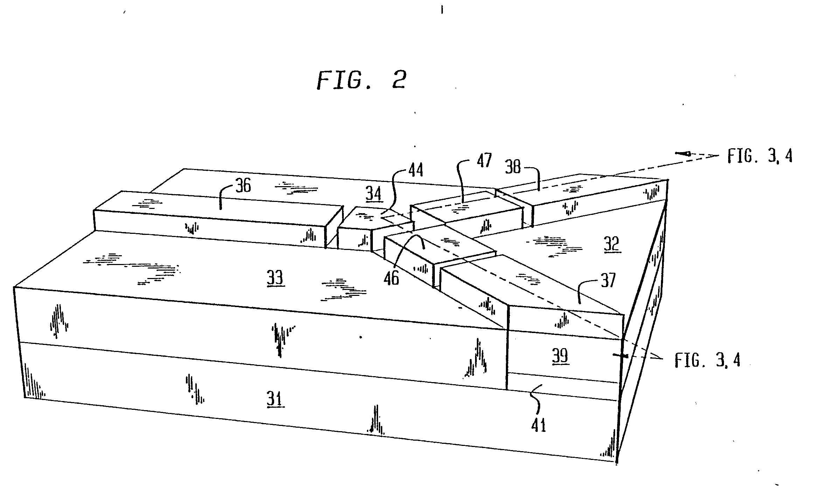

Fig. 2 is a perspective illustration of a branching device in accordance with the invention. A suitable material for substrate 31 is gallium arsenide (GaAs). Triangular region 32 and rhombic shaped regions 33 and 34 are semi-insulating and play no role in the active device structure other than to define the geometry of a Y-shaped active channel region having its base under common contact and terminal 36 with one branch portion extending under terminal 37 and the other branch portion extending under terminal 38. Under terminals 36 and 37 are two contacted zones, one zone 39 of which is shown extending to the edge of the device of Fig. 2 under contact/terminal 37. Under zone 39, zone 41 is used to provide isolation for zone 39. It should be understood that zones 39 and 41 may be though of as respectively corresponding to zones 14 and 18 as depicted in Fig. 1 when terminal 37 is a drain terminal. When terminal 37 is one of two source terminals, then terminal 37 generally corresponds to source terminal 11.

The principle of establishing or interrupting a current path between the common source 11 and drain 13 of Fig. 1 by aligning or misaligning the conductive two-dimensional electron gas in either the upper or lower interface of the channel region 16 may be used to switch the current path between common terminal 36 and terminal 37 to a different path between terminal 36 and another terminal 38 as shown in Fig. 2. Depending upon the voltage potential applied to gate 44 and gate 46, and to gate 47 the conductive two-dimensional electron gas resides in the upper or lower interface of the channel areas under the respective gates. By seleting the electron gas to be in opposite (upper and lower) interfaces of the channel region under the gate area 46 and 47 the conductive path is established only between the common terminal 36 and either terminal 37 or terminal 38 depending upon the voltage applied to gate 44 and thus the two-dimensional electron gas resides in a position (upper or lower interface of the branching channel region) in the area under gate 44. By establishing the conductive two-dimensional electron gas permanently in opposite (upper and lower) portions of the channel under gates 46 and 47, the current path may be switched from terminal 36 to terminal 37 or to terminal 36 to terminal 38. Such switching is accomplished only by one gate voltage change applied to gate 44 shifting the two dimensional electron gas from the lower to the upper interface of the channel 16 or vice versa.

Instead of selecting upper or lower two-dimensional electron gas positions in the channel area under gates 46 and 47 through appropriate bias potential voltages to these gates, it is also possible to permanently select upper or lower interfaces in these channel areas by suitable choice of the structural parameters in these areas; e.g. the thickness or doping of the AlGaAs in the region 17 of Fig. 1 and to corresponding regions in Fig. 2. Then it is not necessary to also position ($n^-$ -GaAs) gates 46 or 47 in those areas.

As has been discussed one application of the switching mechanism may be used to switch on and off a conduction channel between two terminals of device. Another application of the switching mechanism may be used to steer or branch a conduction channel extending from a common terminal to a selected one of two other terminals on the device. In other words instead of switching between on and off states. the device switches a current path terminated at a common terminal between two other terminals. This application is equivalent in basic structure and operation to a very fast acting single pole double throw switch.

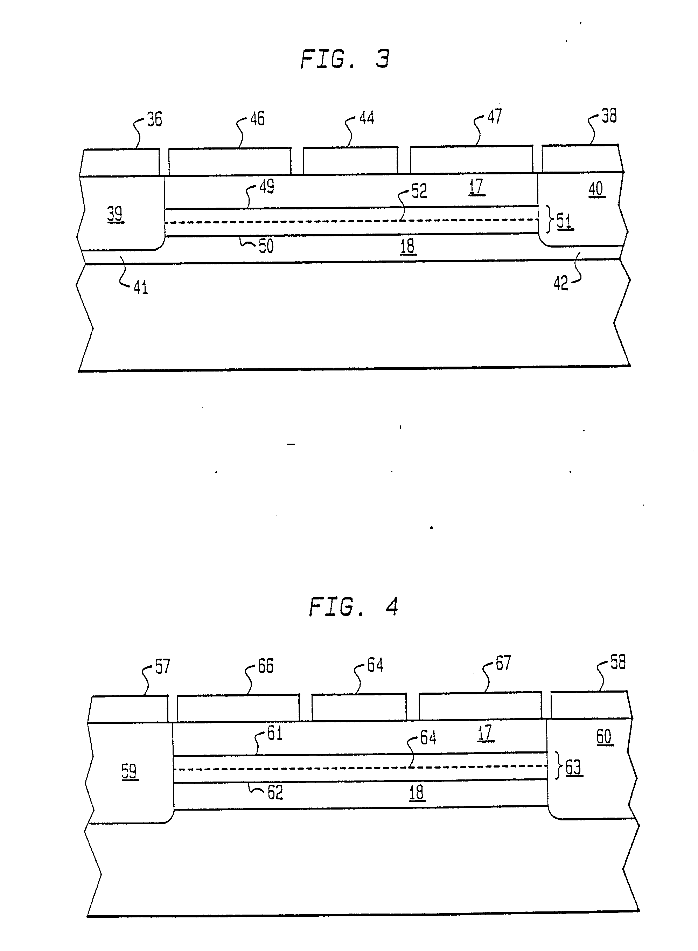

Fig. 3 provides a first cross-sectional view of the internal structure of Fig. 2 take along the indicated V-shaped axis. Fig. 3 illustrates the internal zone structure wherein a source terminal (not shown in Fig.3) serves as the common terminal between two channel terminals. Selector terminal 44 determines whether the 2-DEG is located at interface 49 or 50 for the electrons being injected into drain zone 51 by the common source zone. At the same time, selector terminal 46 is biased at a first potential and polarity to favour one interface location for its localized 2-DEG while selector terminal 47 is biased at another potential and polarity to favor the other interface location for its associated 2-DEG while selector terminal 47 is biased at another potential and polarity to favor the other interface location for its associated 2-DEG. Therefore, alignmentoccurs between the 2-DEG associated with selector 44 and the 2-DEG associated with one selector terminal (for example, selector terminal 46) and displacement occurs between the 2-DEG associated with selector 44 and the 2-DEG associated with the other selector terminal (for example, selector terminal 47). In the situation of this example, conduction will occur between the common source terminal and drain terminal 36 via drain zone 39 and the aligned 2-DEG's at either interface 49 or 50 of channel 51. Following the example, conduction will not occur between the common source terminal and drain terminal 38 due to the misalignment between the DEG associated with selector 44 and the DEG associated with selector 47. It should be noted that Fig. 3 is symmetrical about its middle and that drain zone 39 and 40 have the same dimensions and doping levels. Spacing regions 41 and 42 serve to provide isolation for their corresponding drain zones.

Fig. 4 provides a cross-sectional view of an alternative structure for the branching device of Fig. 2. In this situation, the common terminal (not shown in Fig. 4) is the drain associated with either one of two source terminals. Respectively, associated with each of two source terminals 57 and 58 are source zones 59 and 60. It should also be pointed out that Fig. 4 is symmetrical about its middle region similar to Fig. 3. As far as operation or function is concerned, the same principles are used to provide alignment or displacement between the associated 2-DEGs of selector 64 and selectors 66 and 67. Therefore, the current branching now occurs between a common drain and the two source terminals 57 and 58. Similarly a double heterostructure is provided for the formation of 2-DEGs at either interface 61 or 62 which are also the upper and lower boundaries of bounding channel zone 73.

Other possible variations consistent with the inventive principles present a number of alternatives. For example, it may be desirable at the location of dotted line 74 in Fig. 4 to construct an AlGaAs layer to serve as a tunnel barrier to separate the current paths associated with the 2-DEGs at interfaces 71 and 72. The purpose of this layer would be to achieve a sharper transition in the switching between the two current paths. This arrangement also applies to the other structures illustrated in Fig. 3 and Fig. 1. Such a structural arrangement may be referred to as a dual quantum well structure as opposed to a single quantum well structure without the intermediate tunnel barrier.

Another choice may be made in the selection of the material for the selector elements employed in the various drawing figures. For example, $n^+GaAs$ may be used or a contact of suitable metal may be used. For $n^+GaAs$ contact material no offset voltage will develop in the drain current versus selector or gate voltage along the voltage axis. While in the selection of a metal contact material for the selector terminals, a voltage offset typically of about 0.8 volts will develop due to the difference in work function introduced by the metal-semiconductor contact interface.

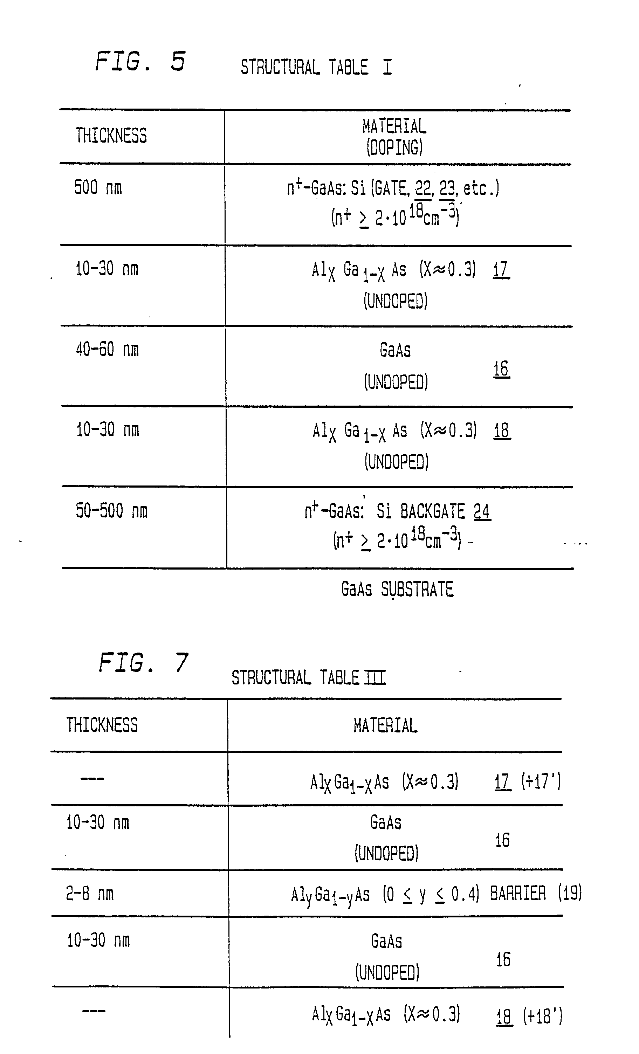

Fig. 5 presents structural information (Structural Table I) providing suitable thicknesses, material, and doping or concentration levels for the various elements depicted in Fig 1. The table of Fig. 5 is arranged vertically to generally correspond to the arrangement of Fig. 1. The layer thickness dimensions are quite thin and listed in nanometers (nm) units for the epitaxial layers. Fig. 5 is a structural version wherein the $Al_xGa_{1-x}As$ layers are undoped.

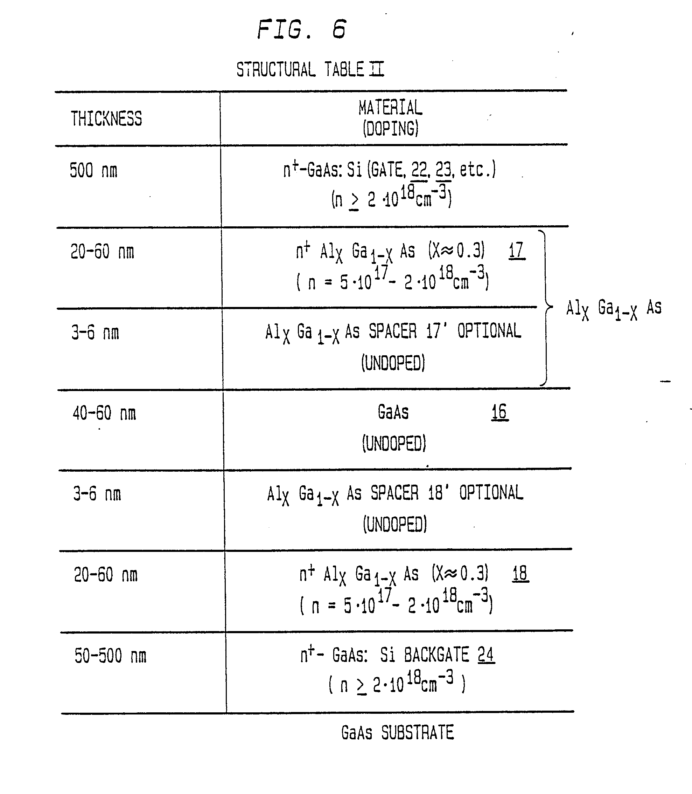

Fig. 6 depicts in structural table II the parameters for a device arrangement wherein the layers are doped with $Al_xGa_{1-x}As$.

Fig. 7 illustrates structural table III which is only directed to channel zone portion applicable to both structural tables I and II wherein an optical barrier layer such as 19 in the middle of channel zone 16 provides a dual quantum well profile for a device in accordance with the principles of the invention. Similarly, an optional barrier layer may be utilized at the location of dashed line 52 in Fig. 3 and the location of dashed line 64 in Fig. 4. This optional barrier serves to improve the separation of the two 2-DEG positions in the channel for the purpose of increasing the sharpness in the electrical switching characteristic of the device.

Various other posibilities are available in constructing the device in accordance with the principles of the invention. For example under certain circumstances, the channel region and/or the barrier may also be doped using different dopants and concentrations at different locations to provide desirable dopant gradients vertically to achieve performance advantages. As previously mentioned, backgate 24 may be omitted in situations advantageous to the processing sequence used in the device fabrication. Instead of the $n^+$-GaAS material for the gate electrodes metal may be used (e.g.,TiPtAu).

There has thus been shown and described novel notice structure which fulfill all the objects and advantages sought therefor. Many changes, modifications, variations and other uses and applications of the subject invention will, however, become apparent to those skilled in the art after considering this specification and the accompanying drawing which discloses the preferred embodiments thereof. All such changes, modifications, variations and other use and applications which do not depart from the spirit and scope of the invention are deemed to be covered by the invention which is limited only be the claims which follow.

## Claims

1. A field effect transistor having at least one source, at least one drain, and a channel extending between them, the field effect transistor comprising a first region and a second region in the channel, each region forming a carrier conduction path, and controlling means for dividing the channel into two portions each having one region of the first and second regions, said controlling means completing a conductive path between source and drain when the two portions each have regions corresponding to either the first or second regions, and said controlling means disrupting a conductive path between source and drain when the two portions each have regions which correspond to different ones of the first and second regions.

2. The field effect transistor of claim 1, wherein said controlling means comprises a gate electrode extending over one of the two portions for moving charge carriers from one region to another in that portion.

3. The field effect transistor of claim 2, wherein said controlling means comprises a second gate electrode extending over the other of the two portions for moving charge carriers from one region to another in that portion, the second gate electrode providing the conductive path between source and drain when the charge carriers of the other portion are aligned with the charge carriers of the one portion so that the charge carriers of both portions are in the same region, and the second gate electrode opening the conductive path between source and drain when the charge carriers of the other portion are displaced from the charge carriers of the one portions so that the charge carriers of each portion are in different regions.

4. The field effect transistor of claim 2, wherein the other of the two portions comprises a material structure wherein charge carriers are only allowed to occupy one of first and second regions so that changes in potential applied to the gate electrode either completes or disrupts the conductive path between the source and drain.

5. The field effect transistor of claim 2 further comprising a second channel joining the channel extending to an additional terminal and having another gate electrode over a third portion of the second channel for moving charge carriers from one region to another.

6. The field effect transistor of claim 5, wherein the electrical potentials applied to the gate electrode and the other gate electrode are different and the charge carriers of the one portion occupy one of the first and second regions while the charge carriers of the third portion occupy the other of the first and second regions.

7. The field effect transistor of claim 6, wherein the additional terminal is a second drain.

8. The field effect transistor of claim 6, wherein the additional terminal is a second source.

9. A field effect transistor having a conduction channel extending between a source and a drain for carrying charge carriers between them, and at least one gate electrode responsive to electrical potential for moving charge carriers from one region to another for completing or disrupting current flow between the source and drain.

10. The field effect transistor of claim 9 wherein the conduction channel includes an intermediate tunnel barrier between one region and the other region.

11. The field effect transistor of claim 9 further comprising a second drain and the conduction channel is bifurcated into a first branch extending to the drain and into a second branch extending to the second drain and the one gate electrode is located at the bifurcation of the two branches and a second gate electrode extending over at least a position of the first branch while a third gate electrode extending over at least a portion of the second branch, the second gate and third gate being biased to force charge carriers in different regions so that a change of bias on the one gate electrode completes conduction between the source and the drain while disrupting conduction between the source and the second drain.

12. The field effect transistor of claim 9 comprising a second source and a bifurcation in the conduction shannel into a first branch extending to the source and the one gate electrode is located at the bifurcation, each branch having a gate electrode biased to force the charge carriers into one region and each branch having charge carriers in the other region from the other branch for enabling the gate electrode at the bifurcation for steering a conduction path from the drain terminal between the two terminals.

13. The field effect transistor of claim 9 wherein the channel zone has an upper interface and a lower interface between it and another type of semiconductor material to form first and second heterojunctions corresponding to one region or the other region wherein each provides a electron gas of charge carriers.

14. The field effect transistor of claim 9 further comprises a bifurcation in the conduction channel and each branch of the conduction channel extending from the bifurcation has a semiconductor material selected in relation its surrounding semiconductor material so that each branch favors charge carrier located in a region opposite to the region of the other branch, and the one gate electrode in response to an electrical potential steering charge carriers between the two branches.

15. The field effect transister of claim 13 further comprising a second drain associated with one branch of the conduction channel and the other branch of the conduction channel associated with the drain while the source is common between the two drains.

16. The field effect transistor of claim 13 further comprising a second source associated with one branch of the conduction channel and the other branch of the conduction channel is associated with the source while the drain is common between the two sources.

## FIG. 1

FIG. 2

0 262 610

## FIG. 3

36    46    44    47    38

39    49    52    17    40

50    51    18

41    42

## FIG. 4

57    66    64    67    58

59    61    64    17    60

62    63    18

## FIG. 5    STRUCTURAL TABLE I

| THICKNESS | MATERIAL (DOPING) |
|---|---|
| 500 nm | $n^+$-GaAs: Si (GATE, 22, 23, etc.) ($n^+ \geq 2\cdot10^{18}$cm$^{-3}$) |
| 10-30 nm | Al$_X$ Ga$_{1-X}$ As (X≈0.3)   17 (UNDOPED) |
| 40-60 nm | GaAs (UNDOPED)   16 |
| 10-30 nm | Al$_X$ Ga$_{1-X}$ As (X≈0.3)   18 (UNDOPED) |
| 50-500 nm | $n^+$-GaAs: Si BACKGATE 24 ($n^+ \geq 2\cdot10^{18}$cm$^{-3}$) |

GaAs SUBSTRATE

## FIG. 7   STRUCTURAL TABLE III

| THICKNESS | MATERIAL |
|---|---|
| ---- | Al$_X$ Ga$_{1-X}$As (X≈0.3)   17 (+17') |
| 10-30 nm | GaAs (UNDOPED)   16 |
| 2-8 nm | Al$_y$ Ga$_{1-y}$As (0 ≤ y ≤ 0.4) BARRIER (19) |
| 10-30 nm | GaAs (UNDOPED)   16 |
| ---- | Al$_X$ Ga$_{1-X}$As (X≈0.3)   18 (+18') |

# FIG. 6

## STRUCTURAL TABLE II

| THICKNESS | MATERIAL (DOPING) | |
|---|---|---|
| 500 nm | $n^+$-GaAs: Si (GATE, 22, 23, etc.) <br> ($n \geq 2 \cdot 10^{18} cm^{-3}$) | |
| 20–60 nm | $n^+$ Al$_X$ Ga$_{1-X}$ As (X $\approx$ 0.3)  17 <br> ( $n = 5 \cdot 10^{17} - 2 \cdot 10^{18} cm^{-3}$) | } Al$_X$ Ga$_{1-X}$ As |
| 3–6 nm | Al$_X$ Ga$_{1-X}$ As SPACER 17' OPTIONAL <br> (UNDOPED) | |
| 40–60 nm | GaAs  16 <br> (UNDOPED) | |
| 3–6 nm | Al$_X$ Ga$_{1-X}$ As SPACER 18' OPTIONAL <br> (UNDOPED) | |
| 20–60 nm | $n^+$ Al$_X$ Ga$_{1-X}$ As (X $\approx$ 0.3)  18 <br> ( $n = 5 \cdot 10^{17} - 2 \cdot 10^{18} cm^{-3}$) | |
| 50–500 nm | $n^+$- GaAs: Si BACKGATE 24 <br> ( $n \geq 2 \cdot 10^{18} cm^{-3}$ ) | |

GaAs SUBSTRATE